Europäisches Patentamt

European Patent Office

Office européen des brevets

(11) Publication number: **0 269 063**
**A2**

## (12) EUROPEAN PATENT APPLICATION

(21) Application number: 87117299.5

(22) Date of filing: 24.11.87

(51) Int. Cl.⁴ **H01L 21/48 , H01L 23/52**

(30) Priority: 25.11.86 JP 278598/86

(43) Date of publication of application:
01.06.88 Bulletin 88/22

(84) Designated Contracting States:
**DE FR GB**

(71) Applicant: **HITACHI, LTD.**
**6, Kanda Surugadai 4-chome**
**Chiyoda-ku Tokyo 101(JP)**

(72) Inventor: **Ishihara, Shousaku**
**Sanii Taun 3-204 600, Enzo**
**Chigasaki-shi(JP)**
Inventor: **Fujita, Tsuyoshi**
**San Haitsu Totsuka 117 2007-27,**
**Kamikuratacho**
**Totsuka-ku Yokohama(JP)**
Inventor: **Kuroki, Takashi**
**Totsuka Hairaizu 536 884-1, Kamikuratacho**
**Totsuka-ku Yokohama(JP)**
Inventor: **Tsuchida, Seiichi**
**39, Yoshikuracho-1-chome**
**Yokosuka-shi(JP)**
Inventor: **Toda, Gyozo**
**23-3, Higashitoyoda-1-chome**
**Hino-shi(JP)**

(74) Representative: **Patentanwälte Beetz sen. -**
**Beetz jun. Timpe - Siegfried -**
**Schmitt-Fumian**
**Steinsdorfstrasse 10**
**D-8000 München 22(DE)**

(54) Mullite ceramic multi-layered substrate and process for producing the same.

(57) The present invention relates to a mullite ceramic multi-layered substrate (1), particularly that suitable for mounting small electronic parts such as LSI chips, etc., and has an object to provide a mullite ceramic multi-layered substrate (1) with a plating film layer (3) of high connection reliability on the surfaces of the substrate (1) and a process for producing the same, characterized in that a plating film layer (3) composed of Ni and B is formed on wiring conductors (2) for protection of the wiring conductors (2) or soldering connection of the electronic parts. With this structure, raising of the plating film (3) at the end parts and development of cracks on the surfaces of substrate (1) can be prevented.

F I G. I

## MULLITE CERAMIC MULTI-LAYERED SUBSTRATE AND PROCESS FOR PRODUCING THE SAME

### BACKGROUND OF THE INVENTION

This invention relates to a mullite ceramic multi-layered substrate and more particularly to a mullite ceramic multi-layered substrate having nickel plated conductors on the surfaces of the substrate.

Ceramic multi-layered substrates have been so far used as circuit substrates for mounting small electronic parts such as LSI chips, etc. owing to their high connection reliability and possibility to reduce their sizes. A mullite ceramic multi-layered substrate composed of mullite as a main component is one example thereof and can be produced in the same manner as the ordinary alumina ceramic multi-layered substrate can, as disclosed in US Patent No. 4,460,916. That is, ceramic raw material powders are bound together by an organic resin to prepare a ceramic green sheet, which will be hereinafter referred to as "green sheet", and the green sheet is subjected to throughhole formation and printing to form wiring conductors and then fired at a predetermined temperature to obtain a multi-layered substrate. Then, the plating is carried out onto the conductors on the surfaces of the substrate for protection of the conductors on the surfaces of the substrate and soldering connection of the electronic parts. The plating has been electroless plating of a film composed of Ni and P. Then, the plating film is subjected to heat treatment and then the substrate is subjected to soldering connection of the electronic parts. The heat treatment must be carried out at a temperature of 600°C or higher so as to obtain a good adhesion of the wiring conductors on the surfaces of the substrate to the plating film.

In the prior art, no thorough consideration is given to the contraction of the plating film during the heat treatment, and thus the so far used plating film composed of Ni and P has such problems that the plating film is raised at the end parts by the heat treatment after the electroless plating, and in an extreme case cracks develop in the mullite body on the surfaces of the multi-layered substrate. The raising at the end parts or development of cracks leads to concentration of a thermal stress due to a difference in the coefficient of thermal expansion between the electronic parts and the multi-layered substrate onto the end parts and also onto the cracks, considerably shortening the connection life and lowering the reliability in soldering connection of the electronic parts.

On the other hand, a case of applying electroless nickel plating to an alumina substrate, using a boron (B)-based reducing agent, is disclosed in Japanese Patent Application Kokai (Laid-open) No. 61-59889, where no consideration is given at all to the mullite ceramic multi-layered substrate.

### SUMMARY OF THE INVENTION

An object of the present invention is to provide a mullite ceramic multi-layered substrate with a plating film layer of high connection reliability and a process for producing the same.

The object of the present invention can be attained by a mullite ceramic multi-layered substrate, which comprises a multi-layered substrate composed of mullite as a main component, wiring conductors formed on the multi-layered substrate and a plating film layer composed of Ni and B and formed on the wiring conductors, wherein the plating film layer is composed of 97.0 to 99.99% by weight of Ni and 3.0 to 0.01% by weight of B and has a thickness of 1.0 to 10 $\mu$m and development of cracks can be prevented by heat treatment at a temperature of 600° to 1,000°C.

When the plating film layer is composed of 98.0 to 99.99% by weight of Ni and 2.0 to 0.01% by weight of B and has a thickness of 1.0 to 8.0 $\mu$m, and when the heat treatment is carried out at a temperature of 600° to 1,000°C, a good effect can be obtained against the poor connection.

The present invention will be described in detail below.

Raising of the plating film at the end parts after the heat treatment and development of cracks on the surfaces of the ceramic multi-layered substrate as mentioned in Background of the Invention are caused by contraction of the plating film layer composed of Ni and P due to its volumic reduction when the plating film layer undergoes phase transition from the amorphous to Ni and $Ni_3P$ during the heat treatment. The contraction ratio of a plating film layer composed of 92 - 99% by weight of Ni and 8 - 1% by weight of P is 0.9 - 0.5% at a heat treatment temperature of lower than 800°C. Since the plating film layer is provided on the conductors on the surfaces of the mullite ceramic multi-layered substrate, a stress develops due to the contraction and the raising at the end parts of the plating film and development of cracks on the surfaces of the substrate are caused. Thus, in order to prevent such raising of the plating film at the end parts and development of cracks, it is necessary to provide a plating film layer, whose stress development accompanying the phase transition during the heat treatment is low. Specifically, it is necessary to provide a plating film layer, whose contraction ratio accompanying the phase transition is low and also whose hardness is low. To this end, a plating film layer must be composed of Ni as pure as possible, that is, must have a P content as low as possible, but it is practically quite difficult to reduce the P content to less than 1% by weight by electroless plating. It is also impossible to apply nickel electroplating to all the conductors on the surfaces of the substrate, because there are electrically isolated wiring patterns.

The present inventors have found that a plating film composed of Ni and B is effective as a plating film layer whose contraction ratio accompanying the phase transition is low and whose hardness is low after the heat treatment. Its appropriate composition range is 98.0 to 99.99% by Ni and 2.0 to 0.01% by weight of B. The contraction ratio of the plating film within this composition is not more than 0.5% at a heat treatment temperature of not more than 1,000°C. The hardness of the plating film after the heat treatment is not more than two-thirds of that of the conventional plating film composed of Ni and P. However, when the heat treatment temperature exceeds 1,000°C, the contraction ratio has been found to be more than 0.5%, and a tendency to raise the plating film at the end parts has been found to appear as in the prior art. Thus, a heat treatment temperature over 1,000°C is not desirable.

The smaller the thickness of the plating film layer, the better, because the stress is caused by the contraction of the plating film owing to its contraction, but the thickness of the plating film layer must be large enough to completely cover all the conductor surfaces. Thus, it is desirable that the plating film layer has a thickness of not more than 8.0 $\mu$m, specifically 1.0 to 8.0 $\mu$m.

## BRIEF DESCRIPTION OF THE DRAWINGS

Fig. 1 is a cross-sectional view of a mullite ceramic multi-layered substrate with a plating film layer composed of Ni and B and formed on the wiring conductors according to the present invention.

Fig. 2 is a cross-sectional view of a mullite ceramic multi-layered substrate with a gold plating film layer formed on the plating film layer composed of Ni and B according to the present invention.

## DESCRIPTION OF THE PREFERRED EMBODIMENTS

The present invention will be described in detail below, referring to Examples and Comparative Example.

Example 1

100 g of ceramic powders composed of 70% by weight of mullite powders having particle sizes of not more than a few $\mu$m and 30% by weight of fine powders of cordierite and silica as a sintering aid was admixed with 8 g of polyvinylbutyral as an organic binder and 45 g of an azeotropic mixture composed of trichloroethylene, tetrachloroethylene and butyl alcohol as solvents and thoroughly mixed in a ball mill to prepare a slurry in which the ceramic powders were uniformly distributed. Successively, the slurry was debubbled with stirring under reduced pressure to remove bubbles from the slurry and then made into a sheet by a doctor-blade casting machine to prepare a green sheet having a thickness of 0.25 mm. The thus prepared green sheet was trimmed at the circumference to make a 200-mm square green sheet. Furthermore, throughholes were made through the green sheet by a piercing die having tungsten carbide pins for vertical connection of the wirings.

Then, a wiring pattern was formed. At first, description will be made of preparation of a tungsten paste as a wiring conductor material.

80 g of tungsten powders having an average particle size of 1.5 $\mu$m, 3 g of ethyl cellulose as an organic binder, and 17 g of diethyleneglycol as a solvent were joined together and kneaded in a grinding mill and a three-roll kneader, and the viscosity of the mixture was adjusted with n-butylcarbitol acetate.

Then, the tungsten paste was filled in the throughholes through the green sheet and also a wiring pattern was formed on the surface of the green sheet by screen printing. Likewise, predetermined patterns were formed on the respective green sheets to be laid one upon another by the screen printing.

Then, the wiring pattern-formed green sheets were laid upon one another and pressed under the pressure of 150 kg/cm² with heating at 100°C to prepare a laminate. The thus prepared green sheet laminate was fired to obtain a mullite ceramic multi-layered substrate. The firing was carried out in a mixed gas atmosphere of nitrogen, hydrogen and steam in a box-type electric furnace at an elevated temperature of 1,600°C.

Then, a plating film layer composed of 99.5% by weight of Ni and 0.5% by weight of B was formed to a thickness of 4 μm on the conductor parts on both surfaces of the fired mullite ceramic multi-layered substrate by Ni electorless plating, and further a gold plating film layer was formed to a thickness of 0.2 μm on the thus formed plating films by electroless plating. Then, the plated mullite ceramic multi-layers substrate was heated in a mixed gas atmosphere of nitrogen and hydrogen at an elevated temperature of 850°C to conduct heat treatment of the plating films.

The surfaces of the heat-treated mullite ceramic multi-layered substrate were inspected with a scanning type electron microscope, and it was found that there was neither raising of the plating films at the end parts nor development of cracks on the substrate.

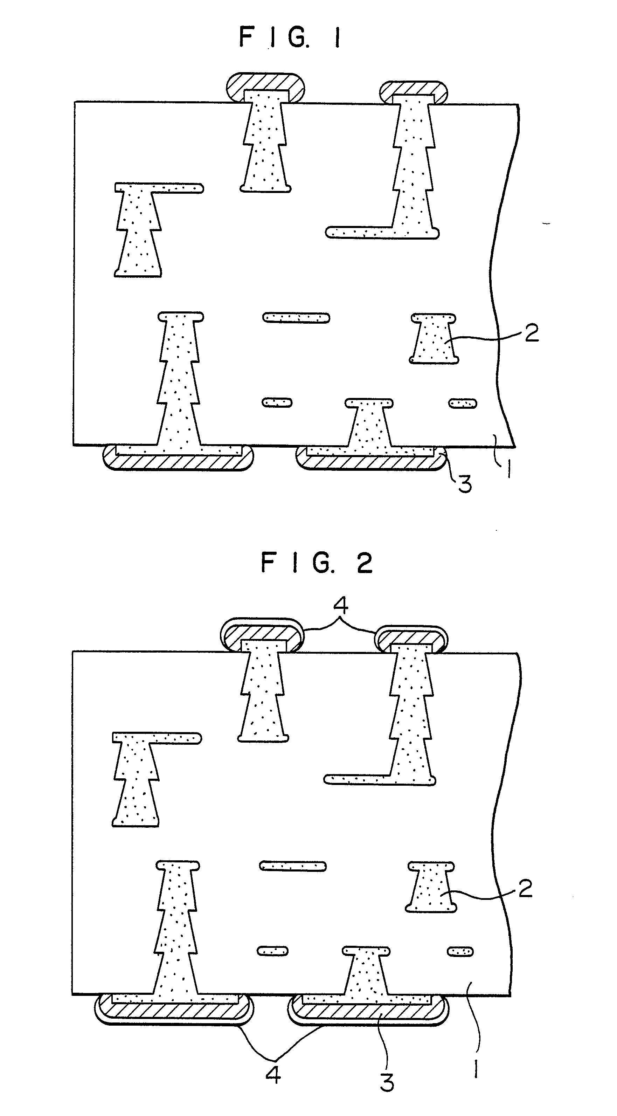

Then, the LSI chips-mounted substrate was subjected to a heat cycle test between -25°C and 150°C to investigate the life of connection between the mullite ceramic multi-layered substrate and LSI chips, and it was found that no poor connection occurred even after 3,000th cycle. The contraction ratio of the plating film of this composition was found to be 0.3%. In Fig. 1, the cross-sectional view of the mullite ceramic multi-layered substrate prepared according to this embodiment of the present invention is shown, and in Fig. 2 the cross-sectional view of the mullite ceramic multi-layered substrate with a gold plating layer formed on the Ni-B plating layer according to this embodiment of the present invention is shown.

Comparative Example

A plating film layer composed of 98% by weight of Ni and 2% by weight of P was formed by electroless plating up to a thickness of 4 μm on both surfaces of a fired mullite ceramic multi-layered substrate prepared in the same manner up to the firing step as in Example 1, and then the plated substrate was subjected to gold plating and heat treatment in the same manner as in Example 1. The surfaces of the heat-treated substrate was inspected. It was found that raising of the plating films at the end parts and development of cracks on the substrate occurred. In the same heat cycle test as in Example 1, poor connection was found after 60th cycle. The contraction ratio of the plating films of this comparative Example composition was found to be 0.6%.

Example 2

A plating film layer composed of 97.0 to 99.99% by weight of Ni and 3.0 to 0.01% by weight of B was formed by electroless plating to a thickness of 1.0 to 10 μm on the conductor parts on both surfaces of fired mullite ceramic multi-layered substrates prepared in the same manner up to the firing step as in Example 1, and then the plated substrates were subjected to further formation of gold plating to a thickness of 0.2 μm by electroless plating and heat treatment at a temperature of 600° to 1,000°C. Then, the surfaces of the substrates were inspected. It was found that neither raising nor development of cracks occurred in the foregoing ranges of the composition, film layer thickness and heat treatment temperature.

In the same heat cycle test as in Example 1, no poor connection was found even after 3,000th cycle when the plating film layers were composed of 98.0 to 99.99% by weight of Ni and 2.0 to 0.01% by weight of B, the film layer thickness was in a range of 1.0 to 8.0 μm and the heat treatment temperature was in a range of 600° to 1,000°C. The contraction ratios of the plating films in these ranges were all found to be not more than 0.5%. Outside these ranges, the contraction ratios exceeded 0.5% and poor connection was found before 3,000th cycle in the heat cycle test.

Example 3

Mullite ceramic multi-layered substrates were prepared in the same manner up to the firing step as in Example 1, except that ceramic powders composed of 50 to 95% by weight of mullite powders having sizes of not more than a few μm and 50 to 5% by weight of fine powders of cordierite and silica was used as a sintering aid, tungsten powders having an average particle size of 0.5 to 6.0 μm was used as the tungsten paste for a wiring conductor material, and a firing temperature of 1,450° to 1,700°C was used. Then, the substrates were subjected to electroless plating and heat treatment in the same manner and same ranges as in Example 2.

Then, the heat-treated substrates were subjected to surface inspection and heat cycle test, and the same results as in Example 2 were obtained within the foregoing composition range of the mullite ceramic powders.

According to the present invention, a mullite ceramic multi-layered substrate of high connection reliability can be provided, because plating film layers having a low stress development during the heat treatment can be obtained without raising of the plating films at the end parts or development of cracks on the mullite body on the surfaces of the multi-layered substrate. 4090

Claims

1. A mullite ceramic multi-layered substrate which comprises a multi-layered substrate (1) composed of mullite as a main component, wiring conductors (2) formed on the substrate (1) and a plating film layer (3) composed of Ni and B and formed on the wiring conductors (2).

2. A mullite ceramic multi-layered substrate according to Claim 1, wherein a gold plating film layer (4) is further provided on the plating film layer (3).

3. A mullite ceramic multi-layer substrate according to Claim 1, wherein the plating film layer (3) is formed by electroless plating.

4. A mullite ceramic multi-layered substrate according to Claim 1, where the wiring conductors (2) are formed on both surfaces of the substrate, and the plating film layer (3) is formed on the wiring conductors (2).

5. A mullite ceramic multi-layered substrate according to Claim 1, wherein the plating film layer (3) is composed of 98.0 to 99.99% by weight of Ni and 2.0 to 0.01% by weight of B.

6. A mullite ceramic multi-layered substrate according to Claim 1, wherein the plating film layer (3) has a thickness of not more than 8.0 μm.

7. A mullite ceramic multi-layered substrate according to Claim 5, wherein the plating film layer (3) has a thickness of not more than 8.0 μm.

8. A mullite ceramic multi-layered substrate according to Claim 1, wherein the substrate (1) is heat-treated at a temperature of not higher than 1,000°C, thereby conducting thorough adhesion of the wiring conductor (2) to the plating film layer (3).

9. A mullite ceramic multi-layered substrate according to Claim 7, wherein the substrate (1) is heat-treated at a temperature of not higher than 1,000°C, thereby conducting thorough adhesion of the wiring conductor (2) to the plating film layer (3).

10. A process for producing a mullite ceramic multi-layered substrate, which comprises preparing a multi-layered substrate composed of mullite as a main component, forming wiring conductors on the substrate and forming a plating film layer composed of Ni and B on the wiring conductors.

11. A process according to Claim 10, wherein a gold plating film layer is further formed on the plating layer.

12. A process according to Claim 10, wherein the plating film layer is formed by electroless plating.

13. A process according to Claim 10, wherein the plating film layer is composed of 98.0 to 99.99% by weight of Ni and 2.0 to 0.01% by weight of B.

14. A process according to Claim 10, wherein the plating film layer has a thickness of not more than 8.0 μm.

15. A process according to Claim 13, wherein the plating film layer has a thickness of not more than 8.0 μm.

16. A process according to Claim 10, wherein the substrate is heat treated at a temperature of not higher than 1,000°C, thereby conducting thorough adhesion of the wiring conductors to the plating film layer.

17. A process according to Claim 15, wherein the substrate is heat treated at a temperature of not higher than 1,000°C, thereby conducting thorough adhesion of the wiring conductors to the plating film layer.

18. A process according to Claim 10, wherein the multi-layered substrate is prepared from ceramic powders composed of 50 to 95% by weight of mullite powders and 50 to 5% by weight of fine powders of cordierite and silica as a sintering aid.

19. A process according to Claim 10, wherein the multi-layered substrate is prepared by laying green sheets having a wiring pattern on the respective surfaces upon one another, pressing the green sheets under a pressure with heating, thereby forming a laminate, and firing the laminate.

20. A process according to Claim 10, wherein the green sheets are each provided with throughholes and a paste is filled in the throughholes.

F I G. 1

F I G. 2